# Europäisches Patentamt
# European Patent Office
# Office européen des brevets

(19)

(11) Numéro de publication : **0 030 173**
**B1**

(12) # FASCICULE DE BREVET EUROPÉEN

(45) Date de publication du fascicule du brevet :
**11.05.83**

(51) Int. Cl.³ : **H 03 H 19/00**, H 03 H 15/02

(21) Numéro de dépôt : **80401541.0**

(22) Date de dépôt : **30.10.80**

(54) **Filtre à capacités commutées à transfert de charges.**

(30) Priorité : **30.11.79 FR 7929506**

(43) Date de publication de la demande :
**10.06.81 Bulletin 81/23**

(45) Mention de la délivrance du brevet :
**11.05.83 Bulletin 83/19**

(84) Etats contractants désignés :
**DE GB NL**

(56) Documents cités :
**FR A 2 437 734**
**US A 4 047 051**
**IEEE Journal of Solid State Circuits, Vol. SC-12,
No. 6, Dec. 1977, pages 592-608**
**NACHRICHTEN ELEKTRONIK, vol. 33, no. 19,
octobre 1979, Berlin, DE R. SCHWEER et al. :
« MOS Schalter-Kondensator-Filter mit Spannungsumkehrschaltern », pages 321-326**
**PROCEEDINGS OF THE IEEE, vol. 67, no. 10,
octobre 1979 New York US C. R. HEWES et al. :
« Applications of CCD and switched Capacitor
Filter Technology », pages 1403-1415**

(73) Titulaire : **THOMSON-CSF**
**173, Boulevard Haussmann**
**F-75379 Paris Cedex 08 (FR)**

(72) Inventeur : **Berger, Jean-Luc**
**"THOMSON-CSF" SCPI 173, bld Haussmann**
**F-75360 Paris Cedex 08 (FR)**
Inventeur : **Coutures, Jean-Louis**
**"THOMSON-CSF" SCPI 173, bld Haussmann**
**F-75360 Paris Cedex 08 (FR)**

(74) Mandataire : **Benichou, Robert et ai**
**THOMSON-CSF SCPI 173 bld Haussmann**
**F-75379 Paris Cedex 08 (FR)**

Jouve, 18, rue St-Denis, 75001 Paris, France

# 0 030 173

## Filtre à capacités commutées à transfert de charges

La présente invention concerne un filtre à capacités commutées à transfert de charges.

Les filtres à capacités commutées sont connus notamment par deux articles de la revue américaine « IEEE Journal of solid-state circuits », volume SC-12, N° 6, décembre 1977, pages 592 à 608.

Les filtres à capacités commutées comportent généralement un amplificateur associé à un réseau de résistances et de capacités dans lequel chaque résistance est réalisée par la mise en série de deux interrupteurs MOS et par une capacité entre le point commun à ces interrupteurs et une tension de référence.

La présente invention concerne un filtre à capacités commutées dans lequel les capacités sont réalisées en technologie MOS et les interrupteurs MOS sont constitués par des grilles à cheval sur les capacités MOS dont elles sont séparées par une couche d'oxyde.

L'une des armatures de chaque capacité MOS est donc constituée par le substrat semi-conducteur sur lequel cette capacité est intégrée et la liaison entre deux capacités MOS dont les armatures constituées par le substrat se trouvent périodiquement reliées, d'après le schéma électrique du filtre, se fait par transfert de charges dans le substrat semi-conducteur sur lequel ces deux capacités sont intégrées et aboutit à l'établissement d'un même potentiel de surface sous ces deux capacités. C'est pourquoi le filtre selon l'invention est appelé filtre à capacités commutées à transfert de charges.

L'autre armature de chaque capacité MOS, qui est donc externe au substrat, reçoit, selon le point où elle est reliée sur le schéma électrique du filtre, soit la tension d'entrée du filtre E, soit une tension continue $V_G$ prise pour référence. Dans le cas où l'armature externe est reliée sur le schéma électrique, périodiquement ou en permanence, et directement ou par l'intermédiaire de l'amplificateur, à l'armature constituée par le substrat d'une autre capacité, cette armature externe reçoit par l'intermédiaire d'un dispositif de lecture et de ré-injection le potentiel de surface sous cette autre capacité.

La présente invention permet de transformer en filtre à capacités commutées à transfert de charges un filtre dont le schéma électrique est quelconque et ne comporte que des résistances et des capacités associées à un amplificateur. On peut ainsi obtenir des filtres à capacités commutées à transfert de charges d'un ordre quelconque en mettant en série des filtres des premier et deuxième ordres.

Les filtres à capacités commutées à transfert de charges présentent notamment par rapport aux filtres à capacités commutées connus, l'avantage de ne pas comporter de capacités parasites sur les capacités du réseau associé à l'amplificateur. On peut ainsi utiliser de faibles valeurs pour les capacités du réseau, et le coût et l'encombrement du filtre peuvent être diminués.

D'autres objets, caractéristiques et résultats de l'invention ressortiront de la description suivante, donnée à titre d'exemple non limitatif et illustrée par les figures annexées qui représentent :

la figure 1,   le schéma électrique d'un filtre passe-haut du second ordre ;

la figure 2,   le schéma du filtre à capacités commutées correspondant au filtre de la figure 1 ;

la figure 3,   un mode de réalisation selon l'invention d'un filtre à capacités commutées à transfert de charges correspondant au filtre des figures 1 et 2 ;

la figure 4,   le schéma électrique d'un filtre passe-bas du second ordre ;

la figure 5,   le schéma du filtre à capacités commutées correspondant au filtre de la figure 4 ;

la figure 6,   un mode de réalisation selon l'invention d'un filtre à capacités commutées à transfert de charges correspondant au filtre des figures 4 et 5 ;

les figures 7a à e,   des diagrammes de phase de signaux susceptibles d'être appliqués aux filtres selon l'invention ;

la figure 8,   un autre mode de réalisation selon l'invention d'un filtre à capacités commutées à transfert de charges correspondant au filtre des figures 1 et 2.

Sur les différentes figures, les mêmes repères désignent les mêmes éléments, mais pour des raisons de clarté, les cotes et proportions des différents éléments ne sont pas respectées.

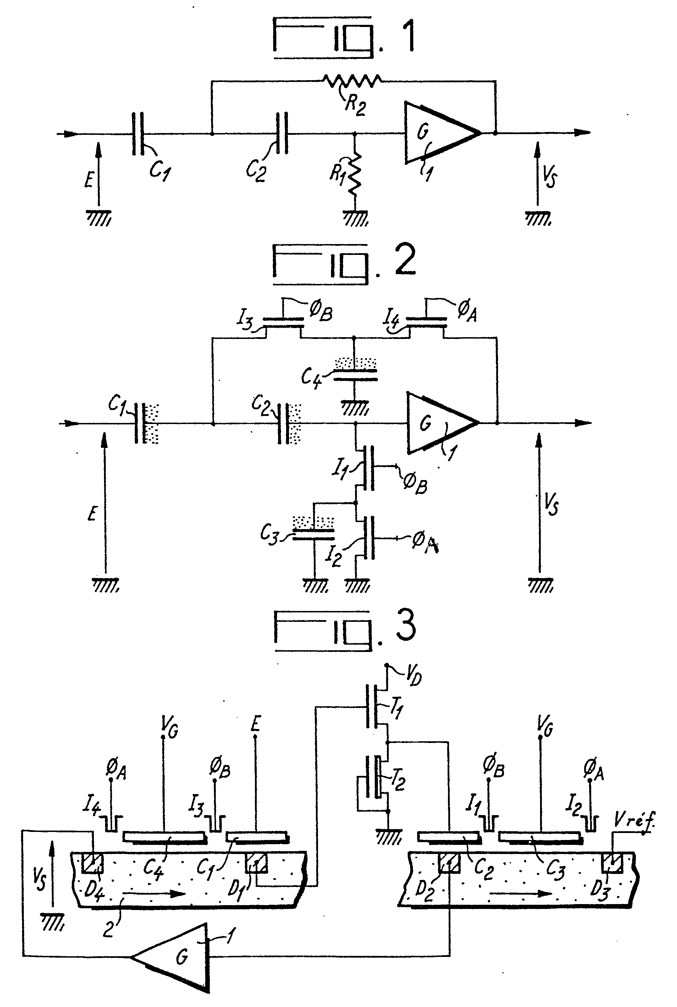

La figure 1 représente le schéma électrique d'un filtre passe-haut du second ordre.

Ce filtre est constitué de deux capacités $C_1$ et $C_2$ en série avec l'entrée d'un amplificateur 1 de gain G. Une résistance $R_1$ est reliée entre l'entrée de l'amplificateur et la masse, tandis qu'une autre résistance $R_2$ assure le bouclage du filtre en reliant la sortie de l'amplificateur au point commun aux capacités $C_1$ et $C_2$.

On appelle E la tension d'entrée du filtre 5 et $V_S$ sa tension de sortie.

La figure 2 représente le schéma du filtre à capacités commutées correspondant au filtre de la figure 1.

Les résistances $R_1$ et $R_2$ du filtre de la figure 1 sont réalisées par la mise en série de deux interrupteurs MOS, respectivement $I_1$, $I_2$ et $I_3$, $I_4$, recevant des signaux de commande $O_A$ et $O_B$, et par une capacité, respectivement $C_3$ et $C_4$, entre le point commun aux deux interrupteurs et la masse.

Sur la figure 2, on a représenté symboliquement, par quelques points, quelle armature des capacités $C_1$ à $C_4$ serait constituée par le substrat semi-conducteur dans le filtre à capacités commutées à transfert de charges selon l'invention. Dans le filtre selon l'invention, seront donc constituées par le substrat l'armature de la capacité $C_1$, autre que celle qui reçoit la tension d'entrée E d'après le schéma électrique, les armatures de $C_3$ et $C_4$ autres que celles reliées à la masse d'après le schéma électrique et enfin, l'armature de la capacité $C_2$ qui est reliée à l'amplificateur 1.

2

**0 030 173**

La figure 3 représente un mode de réalisation selon l'invention d'un filtre à capacités commutées à transfert de charges correspondant au filtre des figures 1 et 2.

Les capacités du filtre sont réalisées en technologie MOS, c'est-à-dire qu'elles sont constituées par une électrode métallique, séparée par une couche d'oxyde (qui n'est pas représentée sur la figure pour des raisons de clarté) d'un substrat semi-conducteur 2, qui est généralement du silicium. L'une des armatures de chaque capacité MOS est donc constituée par le substrat sur lequel elle est intégrée.

Les interrupteurs MOS du filtre sont constitués par des grilles à cheval sur les capacités MOS dont elles sont séparées par une couche d'oxyde supplémentaire (qui n'est également pas représentée sur la figure pour des raisons de clarté).

Lorsqu'un potentiel élevé est appliqué sur l'un de ces interrupteurs, une liaison par transfert de charges s'effectue entre les deux capacités adjacentes à cet interrupteur. Un même potentiel de surface est finalement établi sous ces deux capacités.

Sur le même substrat semi-conducteur, on trouve intégrées à la suite l'une de l'autre, selon le sens de transfert des charges indiqué par une flèche, les capacités $C_4$ et $C_1$ séparées par l'interrupteur $I_3$ commandé par le signal $\phi_B$. Sur le schéma de la figure 2, les armatures, constituées par le substrat, des capacités $C_1$ et $C_4$ se trouvent périodiquement reliées par l'interrupteur MOS $I_3$ commandé par $\phi_B$. Ces capacités sont donc intégrées sur le même substrat semi-conducteur et la liaison entre elles se fait par transfert de charges dans le substrat à travers $I_3$. L'autre armature de la capacité $C_4$ étant reliée sur le schéma de la figure 2 à la masse reçoit une tension continue $V_G$ prise pour référence. L'autre armature de la capacité $C_1$ reçoit, comme sur la figure 2, la tension d'entrée du filtre E. Les capacités $C_2$ et $C_3$ dont les armatures constituées par le substrat se trouvent périodiquement reliées par l'interrupteur $L_1$ commandé par $O_B$ sur la figure 2 sont intégrés sur le même substrat semi-conducteur 2 que celui qui porte $C_4$ et $C_1$ mais se trouvent isolées de la zone du substrat qui porte $C_4$ et $C_1$.

L'autre armature de $C_3$ reliée à la masse sur la figure 2 reçoit la tension $V_G$.

L'autre armature de $C_2$ qui est reliée sur le schéma de la figure 2 à l'armature constituée par le substrat de $C_1$ reçoit le potentiel de surface sous $C_1$ par l'intermédiaire d'un dispositif de lecture et de ré-injection.

Dans le cas de la figure 3, le dispositif de lecture et de ré-injection est constitué par un étage suiveur de tension dont l'entrée est connectée à une diode $D_1$ diffusée dans le substrat sous $C_1$ et dont la sortie est reliée à l'armature externe de $C_2$.

L'étage suiveur de tension peut être constitué, comme sur la figure 3, de deux transistors MOS, à enrichissement $T_1$ et à déplétion $T_2$, en série entre une tension d'alimentation $V_{DD}$ et la masse. L'entrée se fait sur la grille de $T_1$ reliée à $V_{DD}$ et la sortie se fait sur l'électrode commune à $T_1$ et $T_2$, tandis que la grille de $T_2$ est reliée à la masse.

Sur la figure 2, on constate que l'armature constituée par le substrat de la capacité $C_2$ est reliée par l'intermédiaire de l'amplificateur de gain G, et d'un interrupteur $I_4$ commandé par le signal $\phi_A$ à l'armature constituée par le substrat de la capacité $C_4$.

Dans le cas de la figure 3, cela est réalisé par un dispositif de lecture et d'injection de charges, constitué par une diode $D_2$ injectée sous $C_2$ et un étage suiveur de tension connecté à l'entrée de l'amplificateur de gain G. La sortie de l'amplificateur est reliée à une diode $D_4$ d'injection des charges, diffusée dans le même substrat que $C_4$ et $C_1$ et en aval, selon le sens de transfert des charges, de $C_4$ dont elle se trouve séparée par l'interrupteur $I_4$ commandé par $\phi_A$.

L'étage suiveur de tension est généralement inclus dans l'amplificateur de gain G et sur la figure 3, seul cet amplificateur est représenté.

Sur la figure 2, on constate que l'armature constituée par le substrat de $C_3$ est périodiquement reliée par l'intermédiaire d'un interrupteur $I_2$ commandé par $\phi_A$ à la masse.

Dans le cas de la figure 3, cela est réalisé en disposant à la suite de $C_3$ sur le même substrat un interrupteur $I_2$ commandé par $\phi_A$ et une diode $D_3$ reliée en permanence à un potentiel de référence $V_{réf}$ qui peut être la masse du filtre.

Nous allons maintenant établir la fonction de transfert du filtre selon l'invention, représenté sur la figure 3.

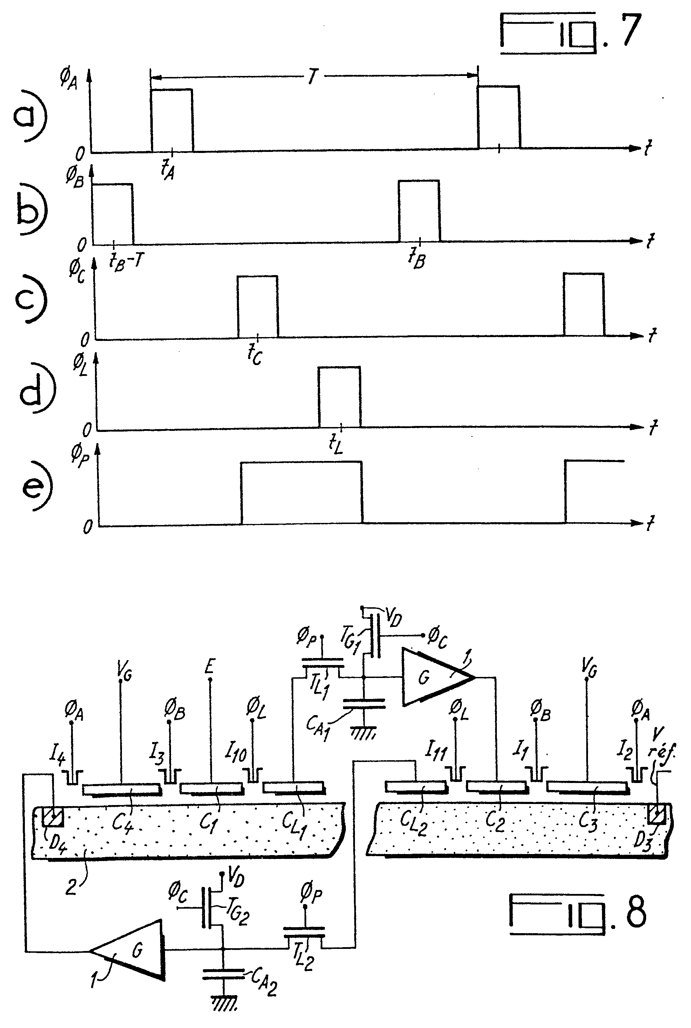

Il faut d'abord préciser que les signaux d'horloge $\phi_A$ et $\phi_B$ appliqués aux interrupteurs MOS de ce filtre sont représentés sur les figures 7a et 7b. Les signaux $\phi_A$ et $\phi_B$ varient sensiblement en créneau entre un niveau bas et un niveau haut avec une période T. De plus, $\phi_A$ et $\phi_B$ ne sont pas simultanément au niveau haut. On appelle $t_A$ l'instant où $\phi_A$ est au niveau haut et $t_B$ l'instant où $\phi_B$ est au niveau haut.

La même tension d'entrée E est maintenue sur $C_1$ entre deux instants $t_B$ successifs et change aux instants $t_B$. Au temps $t_A$, $\phi_A$ est au niveau haut et $\phi_B$ au niveau bas. Le potentiel de surface sous $C_4$ et sous $C_3$ s'écrit :

$$\phi_{S4}(t_A) = G \cdot \phi_{S2}(t_B - T) \text{ et } \phi_{S3}(t_A) = V_{réf}.$$

On peut d'autre part écrire la conservation de la quantité de charges totale d'une part sous $C_4$ et $C_1$ et d'autre part sous $C_2$ et $C_3$ entre les instants $t_A$ et $t_B$ :

$$C_4 [V_G - G\phi_{S2}(t_B - T)] + C_1 [E(t_B - T) - \phi_{S1}(t_B - T)] = C_4 [V_G - \phi_{S1}(t_B)] + C_1[E(t_B) - \phi_{S1}(t_B)]$$

3

$$C_2 [\phi_{S1}(t_B - T) - \phi_{S2}(t_B - T)] + C_3(V_G - V_{réf}) = C_2 [\phi_{S1}(t_B) - \phi_{S2}(t_B)] + C_3 [V_G - \phi_{S2}(t_B)]$$

En passant dans le plan Z et en éliminant $O_{S1}$ de ces deux relations, on obtient :

$$V_S/E = G\phi_{S2}/E = (Z^{-1} - 1)^2/AZ^{-2} - BZ^{-1} + C$$

où A, B et C sont des constantes qui s'expriment en fonction de G et $C_1$, $C_2$, $C_3$, $C_4$.

On constate donc que la fonction de transfert en Z obtenue est celle d'un filtre passe-haut.

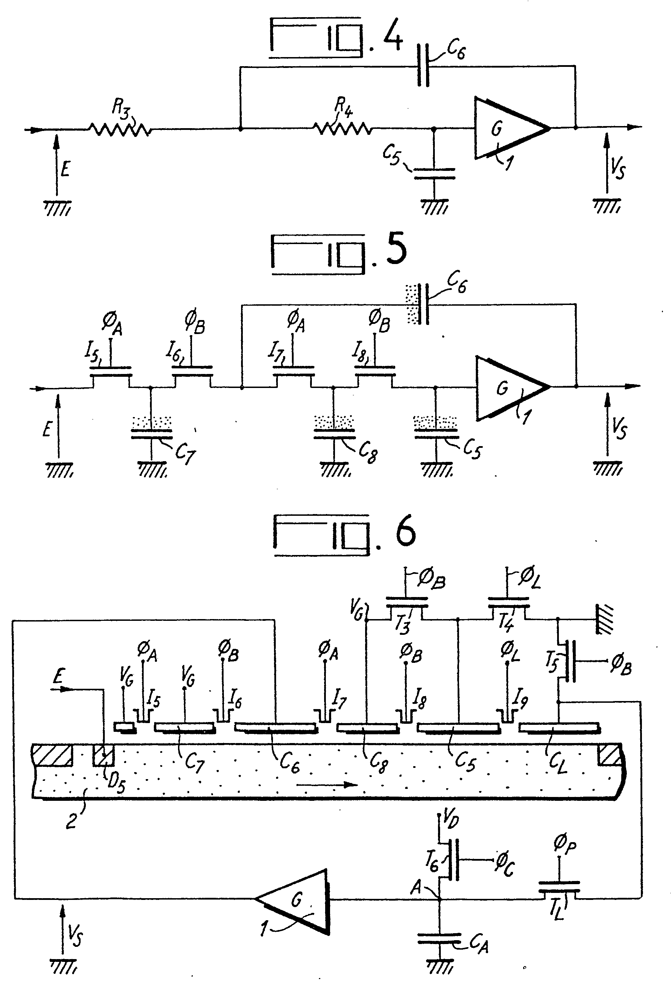

La figure 4 représente le schéma électrique d'un filtre passe-bas du second ordre, du type Sallen-Key, dual de celui qui est représenté sur la figure 1.

Ce filtre comporte deux résistances $R_3$ et $R_4$ en série avec l'entrée de l'amplificateur 1 de gain G. Une capacité $C_5$ est reliée entre l'entrée de l'amplificateur et la masse. Enfin, une capacité $C_6$ entre la sortie de l'amplificateur et le point commun à $R_3$ et $R_4$ assure le bouclage du filtre.

La figure 5 représente le schéma du filtre à capacités commutées correspondant au schéma de la figure 4.

Les résistances $R_3$ et $R_4$ sont réalisées par la mise en série de deux interrupteurs, respectivement $I_5$, $I_6$ et $I_7$, $I_8$ et par une capacité respectivement $C_7$ et $C_8$ entre le point commun aux interrupteurs et la masse.

On a représenté symboliquement par quelques points que les armatures de $C_5$, $C_7$, $C_8$, autres que celles reliées à la masse d'après le schéma électrique, sont constituées par le substrat semi-conducteur dans le filtre selon l'invention. De même, on a représenté symboliquement que l'armature de $C_6$ autre que celle reliée à la sortie de l'amplificateur est constituée par le substrat semi-conducteur.

La figure 6 représente un mode de réalisation selon l'invention d'un filtre à capacités commutées à transfert de charges correspondant au filtre des figures 4 et 5.

On trouve alignées sur le même substrat, selon le sens de transfert des charges indiqué par une flèche, les capacités $C_7$, $C_6$, $C_8$, $C_5$ et une capacité de lecture $C_l$. Chacune de ces capacités est séparée de la suivante par un interrupteur $I_6$, $I_7$, $I_8$, $I_9$.

L'interrupteur $I_7$ est commandé par $\phi_A$, les interrupteurs $I_6$ et $I_8$ sont commandés par $\phi_B$ et enfin l'interrupteur $I_9$ est commandé par un signal $\phi_L$.

L'armature externe des capacités $C_7$ et $C_8$ est reliée directement à $V_G$. L'armature externe de $C_5$ est périodiquement reliée à $V_G$ par l'intermédiaire d'un transistor MOS $T_3$ commandé par le signal $\phi_B$.

La tension d'entrée E est appliquée à une diode $D_5$ diffusée, en aval de $C_7$, dont elle est séparée par une capacité portée à $V_G$ et par un interrupteur $I_5$ commandé par $\phi_A$.

Sur le schéma de la figure 5, l'armature constituée par le substrat de $C_5$ est reliée par l'intermédiaire de l'amplificateur à l'armature externe de $C_6$. Cela est réalisé sur la figure 6 par un dispositif de lecture et de ré-injection relié entre $C_5$ et l'amplificateur, la sortie de l'amplificateur étant connectée à l'armature externe de $C_6$.

Le dispositif de lecture et de ré-injection représenté sur la figure 6 comporte :
— la capacité de lecture $C_l$ séparée de $C_5$ par l'interrupteur $I_9$ commandé par $\phi_L$ ;
— un transistor MOS $T_4$ connecté entre l'armature externe de $C_5$ et la masse, et commandé par $\phi_L$ ;
— un étage constitué par un transistor MOS $T_L$ commandé par un signal $\phi_P$ et relié entre l'armature externe de $C_l$ et l'entrée de l'amplificateur en un point A. Au point A sont également connectés une capacité $C_A$ qui est également reliée à la masse et un transistor $T_6$ commandé par un signal $\phi_C$, et relié à la tension d'alimentation $V_D$
— enfin, un transistor $T_5$ commandé par $\phi_B$ est relié entre l'armature externe de $C_l$ et la masse.

Sur les figures 7c, 7d et 7e, on a représenté à la suite de $\phi_A$ et $\phi_B$, les signaux d'horloge $\phi_C$, $\phi_L$ et $\phi_P$. Ces signaux, comme $\phi_A$ et $\phi_B$, varient sensiblement en créneau entre un niveau bas et un niveau haut avec une période T.

Les signaux $\phi_A$, $\phi_B$, $\phi_C$ et $\phi_L$ ne sont jamais simultanément au niveau haut. Dans l'ordre chronologique, sont au niveau haut $\phi_A$, $\phi_C$, $\phi_L$ puis $\phi_B$ et ensuite de nouveau $\phi_A$, $\phi_C$...

Le signal $\phi_P$ est au niveau haut dès l'instant où $\phi_C$ passe au niveau haut jusqu'à l'instant où $\phi_L$ passe au niveau bas.

Enfin, on appelle $t_C$ et $t_L$ les instants où $\phi_C$ et $\phi_L$ sont au niveau haut.

Nous allons maintenant expliquer le fonctionnement du dispositif de lecture et de ré-injection.

Au temps $t_C$, $\phi_C$ et $\phi_P$ sont au niveau haut. Le transistor $T_6$ conduit et assure la charge de la capacité $C_A$ à un niveau $V_{AO} = V_D$ tel que le transistor $T_L$ dont la grille reçoit $\phi_P$ se trouve polarisé en saturation. La capacité de lecture $C_l$ reçoit alors de $T_L$ sur son armature externe une tension égale à $V_{\phi P} - V_{TL}$, où $V_{\phi P}$ représente le niveau haut du signal $\phi_P$ et $V_{TL}$ la tension de seuil de $T_L$.

Au temps $t_L$, $\phi_L$ et $\phi_P$ sont au niveau haut. Le transistor $T_4$ conduit et relie l'armature externe de $C_5$ à la masse. La charge d'inversion présente sous $C_5$ est transférée à travers l'interrupteur $I_9$ qui est conducteur sous $C_L$.

L'armature externe de $C_L$ est maintenue à un potentiel constant par $T_L$ qui est toujours saturé, ce qui provoque la décharge de la capacité $C_A$ et la modification du potentiel au point A.

Le potentiel du point A au temps $t_L$ s'écrit

4

donc :

$$V_A(t_L) = V_{AO} - Q_5 (t_B - T)/C_A$$

où $Q_5(t_B - T)$ représente la charge présente sous $C_5$ à la fin du cycle précédent, en faisant l'approximation d'une charge d'espace sous $C_L$ au temps $t_L$ peu différente de celle existant sous $C_5$ au temps $t_B - T$, ce qui se justifie particulièrement si $C_5 = C_L$, ce qui est le cas sur la figure 6.

Le maintien d'un potentiel constant sur l'armature externe de $C_L$ lors du transfert des charges à lire sous cette capacité permet la lecture du potentiel de surface sous $C_L$, et donc sous $C_5$, au point A.

Pour assurer un bon fonctionnement du filtre, il faut que l'amplificateur 1 comporte un étage translateur de niveau continu de façon que :

$$V_S(t_L) = V_G - Q_5 (t_B - T)/C_A$$

En effet, au temps $t_A$, un potentiel de surface commun est établi entre $C_6$ et $C_8$. Pour qu'il soit possible d'établir ce potentiel de surface commun, il est préférable que la tension appliquée à $C_6$ en l'absence de signal de lecture soit la même que celle appliquée à $C_8$, c'est-à-dire la tension de référence $V_G$.

Au temps $t_B$, $\phi_B$ est au niveau haut et le transistor $T_5$ relie l'armature externe de $C_L$ à la masse, ce qui provoque le retour des charges lues au temps $t_L$ sous $C_5$.

En écrivant la conservation des charges aux différents instants sur les capacités du filtre, on obtient dans le plan Z la fonction de transfert du filtre qui s'écrit :

$$V_S(Z)/E\ (Z) = G.Z(-2 + \beta)/AZ^{-3} + BZ^{-2} - CZ^{-1}+D$$

où A, B, C, D et G sont des constantes qui s'expriment en fonction des valeurs de $C_5$, $C_6$, $C_7$ et $C_8$, et où $\beta = t_B - t_L$.

Le filtre obtenu a une réponse en basse fréquence analogue à celle d'un filtre du second ordre. A la fréquence de Nyquist, il existe un pôle réel, mais il ne trouble pas le fonctionnement en basse fréquence.

La figure 8 représente un autre mode de réalisation selon l'invention d'un filtre à capacités commutées à transfert de charges correspondant au filtre des figures 1 et 2.

La figure 8 diffère de la figure 3 uniquement par les dispositifs de lecture et de ré-injection utilisés. Les dispositifs utilisés sur la figure 8 sont les mêmes que celui qui est utilisé sur la figure 6 pour le filtre passe-bas.

Ainsi, le potentiel de surface sous $C_1$ et $C_2$ est lu grâce à un transfert des charges sous deux capacités de lecture $CL_1$ et $CL_2$ séparés de $C_1$ et $C_2$ par des interrupteurs $I_{10}$ et $I_{11}$ recevant $\phi_L$. Comme dans le cas de la figure 6, le transfert des charges sous les capacités de lecture $CL_1$ et $CL_2$ est assuré par des transistors MOS reliés entre l'armature externe de $C_1$ et $C_2$ et la masse et commandés par $\phi_L$ et le retour des charges sous $C_1$ et $C_2$ est assuré par des transistors MOS reliés entre l'armature externe de $CL_1$ et $CL_2$ et la masse et commandés par $\phi_B$. Ces transistors ne sont pas représentés sur la figure 8.

Il serait de même possible d'utiliser le dispositif de lecture et de ré-injection de la figure 3 à la réalisation d'un filtre à capacités commutées à transfert de charges correspondant aux figures 4 et 5.

Enfin, il est bien entendu que les schémas des figures 1 et 4 ne sont donnés qu'à titre d'exemple et que l'invention s'applique aux filtres dont le schéma électrique est quelconque et ne comporte que des résistances et des capacités associées à un amplificateur.

## Revendications

1. Filtre à capacités commutées à transfert de charges, dont le schéma électrique comporte un amplificateur (G) associé à un réseau de résistances ($R_1$, $R_2$, Fig. 1) et de capacités ($C_1$, $C_2$, Fig. 1) dans lequel chaque résistance est réalisée par la mise en série de deux interrupteurs MOS ($I_1$, $I_2$ resp. $I_3$, $I_4$, Fig. 2) et par une capacité ($C_3$ resp. $C_4$, Fig. 2) entre le point commun à ces interrupteurs et la masse, caractérisé en ce que les capacités ($C_1$ à $C_4$, Fig. 2) sont réalisées en technologie MOS et les interrupteurs MOS ($I_1$ à $I_4$, Fig. 2) sont constitués par des grilles ($I_1$ à $I_4$, Fig. 3) à cheval sur les capacités MOS ($C_1$ à $C_4$, Fig. 3) dont elles sont séparées par une couche d'oxyde, l'une des armatures de chaque capacité étant réalisée par le substrat semi-conducteur sur lequel elle est intégrée, et caractérisé en ce que la liaison entre deux capacités dont les armatures constituées par le substrat se trouvent périodiquement reliées d'après le schéma électrique se fait par transfert de charges dans le substrat semi-conducteur sur lequel ces deux capacités sont intégrées, et aboutit à l'établissement d'un même potentiel de surface sous ces deux capacités, l'autre armature externe au substrat de chaque capacité recevant selon le point où elle est reliée sur le schéma électrique, la tension d'entrée du filtre (E), une tension continue $V_G$ prise pour référence ou recevant, dans le cas où cette armature externe est reliée sur le schéma électrique, périodiquement ou en permanence et directement ou par l'intermédiaire de l'amplificateur, à l'armature constituée par le substrat d'une autre capacité, le potentiel de surface sous cette autre capacité par l'intermédiaire d'un dispositif ($T_1$, $T_2$, Fig. 3, $I_9$, $C_L$, $T_4$, $T_L$, $C_A$, Fig. 6 ; $C_{L2}$, $T_{L2}$,

$C_{A2}$, $T_{G2}$, Fig. 8) de lecture et de ré-injection.

2. Filtre selon la revendication 1, caractérisé en ce que le dispositif de lecture et de ré-injection est constitué par un étage suiveur de tension dont l'entrée est reliée à une diode ($D_1$) diffusée dans le substrat semi-conducteur (2) sur lequel est intégrée une capacité ($C_1$) et dont la sortie est reliée à l'armature externe d'une autre capacité ($C_2$).

3. Filtre selon la revendication 2, caractérisé en ce que l'étage suiveur de tension est constitué par deux transistors MOS en série entre une tension d'alimentation ($V_D$) et la masse, l'entrée de l'étage se faisant sur la grille du transistor MOS, à enrichissement, ($T_1$), relié à la tension d'alimentation et la sortie de l'étage se faisant sur l'électrode commune aux deux transistors, tandis que la grille du transistor MOS, à déplétion, ($T_2$), relié à la masse est également connectée à la masse.

4. Filtre selon la revendication 1, caractérisé en ce que le dispositif de lecture et de ré-injection comporte :
— une capacité MOS de lecture ($C_L$) intégrée sur le substrat à la suite de la capacité ($C_5$) dont le potentiel de surface doit être lu, un interrupteur MOS ($I_9$) assurant la liaison entre ces deux capacités ;
— un transistor MOS ($T_4$) relié entre l'armature externe de la capacité ($C_5$) à lire et la masse, ce transistor étant rendu conducteur alors que l'interrupteur ($I_9$) permet le transfert des charges de la capacité à lire ($C_5$) vers la capacité de lecture ($C_L$) ;
— un étage, relié à l'armature externe de la capacité de lecture ($C_L$) assurant le maintien d'un potentiel constant sur l'armature externe de la capacité de lecture lors du transfert des charges sous cette capacité, cet étage étant relié, directement ou par l'intermédiaire de l'amplificateur (1), à l'armature externe d'une autre capacité ($C_6$).

5. Filtre selon la revendication 4, caractérisé en ce que cet étage est constitué par un transistor MOS ($T_L$) en saturation relié entre l'armature externe de la capacité de lecture ($C_L$) et un point A et par une capacité ($C_A$) entre le point A et la masse, cette capacité étant périodiquement chargée avant l'arrivée des charges sous la capacité de lecture et déchargée par l'arrivée des charges sous la capacité de lecture.

6. Filtre selon la revendication 5, caractérisé en ce qu'un transistor MOS ($T_5$) relié entre l'armature externe de la capacité de lecture ($C_L$) et la masse assure périodiquement le retour des charges de la capacité de lecture ($C_L$) vers la capacité à lire ($C_5$) et en ce qu'un transistor MOS ($T_6$) relié entre le point A et une tension d'alimentation assure périodiquement la charge de la capacité ($C_A$) reliée au point A.

7. Filtre selon l'une des revendications 4 à 6, caractérisé en ce qu'un étage translateur de niveau continu est relié au point A, et translate le niveau continu du signal obtenu au point A de $V_{AO}$, qui est la tension aux bornes de la capacité ($C_A$) avant l'arrivée des charges sous la capacité de lecture, à $V_G$.

8. Filtre selon l'une des revendications 2 à 7, dont le schéma électrique est constitué de deux capacités $C_1$ et $C_2$ en série avec l'entrée de l'amplificateur (1), d'une résistance entre l'entrée de l'amplificateur et la masse et d'une résistance de bouclage constituée de deux interrupteurs et d'une capacité $C_4$ entre la sortie de l'amplificateur et le point commun aux capacités $C_1$ et $C_2$, caractérisé en ce que l'armature constituée par le substrat de la capacité $C_1$ est reliée sur le schéma électrique à l'armature externe de la capacité $C_2$, et en ce qu'un dispositif de lecture et de ré-injection est relié entre l'armature constituée par le substrat de $C_1$ et l'armature externe de $C_2$.

9. Filtre selon la revendication 8, caractérisé en ce que l'armature constituée par le substrat de $C_2$ est reliée, sur le schéma électrique, par l'intermédiaire de l'amplificateur (1) et d'un interrupteur ($I_4$) à l'armature constituée par le substrat de $C_4$ et caractérisé en ce qu'un dispositif de lecture et de ré-injection est relié entre l'armature constituée par le substrat de la capacité $C_2$ et l'amplificateur, l'amplificateur étant relié à une diode d'injection des charges ($D_4$) intégrée dans le même substrat et en amont selon le sens de transfert des charges de la capacité $C_4$ dont elle est séparée par un interrupteur ($I_4$).

10. Filtre selon l'une des revendications 2 à 7, dont le schéma électrique est constitué de deux résistances en série avec l'entrée de l'amplificateur, d'une capacité $C_5$ entre l'entrée de l'amplificateur et la masse et d'une capacité de bouclage $C_6$ entre la sortie de l'amplificateur et le point commun aux deux résistances, caractérisé en ce que l'armature constituée par le substrat de la capacité $C_5$ est reliée, sur le schéma électrique, par l'intermédiaire de l'amplificateur à l'armature externe de la capacité $C_6$ et en ce qu'un dispositif de lecture et de ré-injection est relié entre l'armature constituée par le substrat de $C_5$ et l'entrée de l'amplificateur dont la sortie est connectée à l'armature externe de la capacité $C_6$.

## Claims

1. Switched capacities charge transfer filter the electric circuit of which comprises an amplifier (G) associated with a network of resistors ($R_1$, $R_2$, Fig. 1) and of capacities ($C_1$, $C_2$, Fig. 1) in which each resistor is formed by the series connection of two MOS interrupters ($I_1$, $I_2$ and $I_3$, $I_4$, respectively, Fig. 2) and by a capacity ($C_3$ and $C_4$, respectively, Fig. 2) between the common point of these interrupters and ground, characterized in that the capacities ($C_1$ to $C_4$, Fig. 2) are formed in MOS technology and the MOS interrupters ($I_1$ to $I_4$, Fig. 2) are formed by gates ($I_1$ to $I_4$, Fig. 3) straddling the MOS capacities ($C_1$ to $C_4$, Fig. 3) of which they are separated by an oxide layer, one of the coatings of each capacity being formed by the semiconductor substrate on which it is integrated, and characterized in that the connection between two capacities of which the coatings formed by the substrate are periodically connected in accordance with the electric diagram, is made by charge transfer within the semiconductor substrate on which the two capacities are integrated, leading to the establishment of the same surface potential beneath these two capacities, the other coating of each capacity which is outside the substrate receiving, depending on the point where it is connected in the electric diagram, the input voltage (E) of the filter, a continuous voltage $V_G$ taken as a reference or, in case said external coating is connected periodically or permanently, directly or through the amplifier, to the coating of another capacity formed by the substrate, to the surface potential beneath said other capacity through a reading and reinjection device ($T_1$, $T_2$, Fig. 3 ; $I_9$, $C_{L1}$, $T_4$, $T_L$, $C_A$, Fig. 6 ; $C_{L2}$, $T_{L2}$, $C_{A2}$, $T_{G2}$, Fig. 8).

2. Filter in accordance with claim 1, characterized in that the reading and reinjection device is formed by a voltage follower stage the input of which is connected to a diode ($D_1$) diffused into the semiconductor substrate (2) on which a capacity $C_1$ is integrated, and the output of which is connected to the external coating of another capacity ($C_2$).

3. Filter in accordance with claim 2, characterized in that the voltage follower stage is formed by two MOS transistors connected in series between a supply voltage ($V_D$) and ground, the input of the stage being formed by the gate of the enrichment MOS transistor ($T_1$) connected to the supply voltage and the output of the stage being formed by the common electrodes of the two transistors, while the gate of the depletion MOS transistor ($T_2$) connected to ground is also connected to ground.

4. Filter in accordance with claim 1, characterized in that the reading and reinjection device comprises :
— a MOS reading capacity ($C_L$) integrated on the substrate following the capacity ($C_5$) of which the surface potential is to be read, a MOS interrupter ($I_9$) assuring the connection between these two capacities ;
— a MOS transistor ($T_4$) connected between the external coating of the capacity ($C_5$) to be read and ground, this transistor being rendered conducting while the interrupter ($I_9$) allows the charge transfer from the capacity to be read ($C_5$) towards the reading capacity ($C_L$) ;
— a stage which is connected to the external coating of the reading capacity ($C_L$) and allowing the maintenance of a constant potential at the external coating of the reading capacity during the charge transfer beneath this capacity, this stage being directly or through the amplifier (1) connected to the external coating of another capacity ($C_6$).

5. Filter in accordance with claim 4, characterized in that this stage is formed by a saturated MOS transistor ($T_L$) connected between the external coating of the reading capacity ($C_L$) and a point A, and by a capacity ($C_A$) between the point A and ground, this capacity being periodically charged prior to the arrival of the charges beneath the reading capacity and discharged by the arrival of the charges beneath the reading capacity.

6. Filter in accordance with claim 5, characterized in that one MOS transistor ($T_5$) connected between the external coating of the reading capacity ($C_L$) and ground periodically assures the returning of the charges from the reading capacity ($C_L$) towards the capacity ($C_5$) to be read, and in that a MOS transistor ($T_6$) connected between the point A and a supply voltage periodically assures the charging of the capacity ($C_A$) connected to the point A.

7. Filter in accordance with any of claims 4 to 6, characterized in that a continuous level translation stage is connected to the point A and translates the continuous level of the signal obtained at point A from $V_{AO}$ which is the voltage at the terminals of the capacity ($C_A$) prior to the arrival of the charges beneath the reading capacity, to $V_G$.

8. Filter in accordance with any of claims 2 to 7, the electric diagram of which is formed of two capacities $C_1$ and $C_2$ in series with the input of the amplifier (1), a resistor between the input of the amplifier and ground and a looping resistor formed by two interrupters and a capacity $C_4$ between the output of the amplifier and the common point of the capacities $C_1$ and $C_2$, characterized in that the coating of the capacity $C_1$ formed by the substrate is connected to the external coating of the capacity $C_2$ within the electric circuit, and in that a reading and reinjection device is connected between the coating of $C_1$ formed by the substrate and the external coating of $C_2$.

9. Filter in accordance with claim 8, characterized in that the coating of $C_2$ formed by the substrate is connected, within the electric circuit, to the coating of $C_4$ formed by the substrate through the amplifier (1) and an interrupter ($I_4$), and characterized in that a reading and reinjection device is connected between the coating of the capacity $C_2$ formed by the substrate and the amplifier, the amplifier being connected to a charge injection diode ($D_4$) integrated into the same substrate upstream from the capacity $C_4$ in the charge transfer direction, from which it is separated by an interrupter ($I_4$).

10. Filter in accordance with any of claims 2 to 7, the electric diagram of which is formed by two resistors in series with the input of the amplifier, a capacity $C_5$ between the input of the amplifier and ground and a looping capacity $C_6$ between the output of the amplifier and the common point of the two resistors, characterized in that, in the electric diagram, the coating of the capacity $C_5$ formed by the substrate is connected to the external coating of the capacity $C_6$ through the amplifier, and in that a reading and reinjection device is connected between the coating of $C_5$ formed by the substrate and the input of the amplifier the output of which is connected to the external coating of the capacity $C_6$.

**Ansprüche**

1. Ladungsverschiebefilter mit geschalteten Kapazitäten, dessen elektrisches Schaltschema einen Verstärker (G) enthält, der einem Netzwerk aus Widerständen ($R_1$, $R_2$, Fig. 1) und aus Kapazitäten ($C_1$, $C_2$, Fig. 1) zugeordnet ist, worin jeder Widerstand durch die Reihenschaltung von zwei MOS-Unterbrechern ($I_1$, $I_2$ bzw. $I_3$, $I_4$, Fig. 2) und durch eine Kapazität ($C_3$ bzw. $C_4$, Fig. 2) zwischen dem gemeinsamen Punkt dieser Unterbrecher und Masse gebildet ist, dadurch gekennzeichnet, daß die Kapazitäten ($C_1$ bis $C_4$, Fig. 2) in MOS-Technologie verwirklicht sind und die MOS-Unterbrecher ($I_1$ bis $I_4$, Fig. 2) durch rittlings über den MOS- Kapazitäten ($C_1$ bis $C_4$, Fig. 3) angeordnete Elektroden ($I_1$ bis $I_4$, Fig. 3) gebildet sind, von denen sie durch eine Oxidschicht getrennt sind, wobei einer der Beläge jeder Kapazität durch das Halbleiterssubstrat gebildet ist, auf dem sie integriert ist, und ferner dadurch gekennzeichnet, daß die Verbindung zwischen zwei Kapazitäten, deren durch das Substrat gebildete Beläge gemäß dem elektrischen Schaltbild periodisch miteinander verbunden werden, durch Ladungsüberführung in dem Halbleitersubstrat geschieht, auf dem diese beiden Kapazitäten integriert sind, und zum Aufbau desselben Oberflächenpotentials unter diesen beiden Kapazitäten führt, wobei der andere, außerhalb des Substrats befindliche Belag jeder Kapazität je nach der Stelle, wo er an das elektrische Schaltbild angeschlossen ist, die Eingangsspannung (E) des Filters, eine als Bezugswert angenommene Gleichspannung $V_G$ oder, wenn dieser äußere Belag in dem elektrischen Schaltbild periodisch oder dauernd, direkt oder über den Verstärker mit dem durch das Substrat gebildeten Belag der anderen Kapazität verbunden wird, das Oberflächenpotential unter der anderen Kapazität über eine Lese- und Rückinjektionsvorrichtung ($T_1$, $T_2$, Fig. 3 ; $I_9$, $C_L$, $T_4$, $T_L$, $C_A$, Fig. 6 ; $C_{L2}$, $T_{L2}$, $C_{A2}$, $T_{G2}$, Fig. 8) empfängt.

2. Filter nach Anspruch 1, dadurch gekennzeichnet, daß die Lese- und Rückinjektionsvorrichtung aus einer Spannungsfolgerstufe gebildet ist, deren Eingang mit einer Diode ($D_1$) verbunden ist, die in das Halbleitersubstrat (2) eindiffundiert ist, auf dem eine Kapazität ($C_1$) integriert ist, und dessen Ausgang mit dem äußeren Belag einer anderen Kapazität ($C_2$) verbunden ist.

3. Filter nach Anspruch 2, dadurch gekennzeichnet, daß die Spannungsfolgerstufe durch zwei MOS-Transistoren gebildet ist, die in Reihe zwischen einer Versorgungsspannung ($V_D$) und Masse liegen, wobei der Eingang dieser Stufe durch das Gate des MOS-Transistors ($T_1$) vom Anreicherungstyp gebildet ist, welcher mit der Versorgungsspannung verbunden ist, während der Ausgang dieser Stufe an der diesen beiden Transistoren gemeinsamen Elektrode gebildet ist, wobei das Gate des MOS-Transistors ($T_2$) vom Verarmungstyp, der mit Masse verbunden ist, ebenfalls mit Masse verbunden ist.

4. Filter nach Anspruch 1, dadurch gekennzeichnet, daß die Lese- und Rückinjektionsvorrichtung umfaßt :

— eine Lese-MOS-Kapazität ($C_L$), die auf dem Substrat im Anschluß an diejenige Kapazität ($C_5$) integriert ist, deren Oberflächenpotential gelesen werden soll, wobei ein MOS-Unterbrecher ($I_9$) die Verbindung zwischen diesen beiden Kapazitäten gewährleistet ;

— einen MOS-Transistor ($T_4$), der zwischen den äußeren Belag der auszulesenden Kapazität ($C_5$) und Masse geschaltet ist, wobei dieser Transistor leitend gemacht ist, während der Unterbrecher ($I_9$) die Überführung der Ladungen von der auszulesenden Kapazität ($C_5$) zu der Lesekapazität ($C_L$) ermöglicht ;

— eine mit dem äußeren Belag der Lesekapazität ($C_L$) verbundene Stufe, die die Aufrechterhaltung eines konstanten Potentials an dem äußeren Belag der Lesekapazität während der Überführung der Ladungen unter diese Kapazität gewährleistet, wobei diese Stufe direkt oder über den Verstärker (1) mit dem äußeren Belag einer anderen Kapazität ($C_6$) verbunden ist.

5. Filter nach Anspruch 4, dadurch gekennzeichnet, daß diese Stufe aus einem gesättigten MOS-Transistor ($T_L$) gebildet ist, der zwischen den äußeren Belag der Lesekapazität ($C_L$) und einen Punkt A geschaltet ist, sowie durch eine Kapazität ($C_A$) zwischen dem Punkt A und Masse gebildet ist, wobei diese Kapazität periodisch vor der Ankunft der Ladungen unter der Lesekapazität geladen und durch die Ankunft der Ladungen unter der Lesekapazität entladen wird.

6. Filter nach Anspruch 5, dadurch gekennzeichnet, daß ein MOS-Transistor ($T_5$), der zwischen den äußeren Belag der Lesekapazität ($C_L$) und Masse geschaltet ist, periodisch die Rückkehr der Ladungen von der Lesekapazität ($C_L$) zu der zu lesenden Kapazität ($C_5$) gewährleistet, und daß ein MOS-Transistor ($T_6$), der zwischen den Punkt A und eine Versorgungsspannung geschaltet ist, periodisch das Laden der mit dem Punkt A verbundenen Kapazität ($C_A$) gewährleistet.

7. Filter nach einem der Ansprüche 4 bis 6, dadurch gekennzeichnet, daß eine Gleichspannungsumsetzstufe mit dem Punkt A verbunden ist und den Gleichspannungspegel des am Punkt A erhaltenen Signals von $V_{AO}$, der Spannung an den Anschlüssen der Kapazität ($C_A$) vor der Ankunft der Ladungen unter der Lesekapazität, auf $V_G$ umsetzt.

8. Filter nach einem der Ansprüche 2 bis 7, dessen elektrisches Schema aus zwei Kapazitäten $C_1$ und $C_2$ in Reihe mit dem Eingang des Verstärkers (1), aus einem Widerstand zwischen dem Eingang des Verstärkers und Masse sowie aus einem Rückschleifwiderstand gebildet ist, der aus zwei Unterbrechern und einer Kapazität ($C_4$) zwischen dem Ausgang des Verstärkers und dem gemeinsamen Punkt der Kapazitäten $C_1$ und $C_2$ gebildet ist, dadurch gekennzeichnet, daß der durch das Substrat gebildete Belag der Kapazität $C_1$ in dem elektrischen Schema mit dem äußeren Belag der Kapazität $C_2$ verbunden ist und daß eine Lese und Rückinjektionsvorrichtung zwischen den durch das Substrat gebildeten Belag von $C_1$

8

und den äußeren Belag von $C_2$ geschaltet ist.

9. Filter nach Anspruch 8, dadurch gekennzeichnet, daß der durch das Substrat gebildete Belag von $C_2$ in dem elektrischen Schema über den Verstärker (1) und über einen Unterbrecher ($I_4$) mit dem durch das Substrat gebildeten Belag von $C_4$ verbunden ist und ferner dadurch gekennzeichnet, daß eine Lese- und Rückinjektionsvorrichtung zwischen den durch das Substrat gebildeten Belag der Kapazität $C_2$ und den Verstärker geschaltet ist, wobei der Verstärker mit einer Ladungsinjektionsdiode ($D_4$) verbunden ist, die in demselben Substrat integriert ist, und zwar in Ladungsüberführungsrichtung vor der Kapazität $C_4$, von der sie durch einen Unterbrecher ($I_4$) getrennt ist.

10. Filter nach einem der Ansprüche 2 bis 7, dessen elektrisches Schema aus zwei Widerständen in Reihe mit dem Eingang des Verstärkers, aus einer Kapazität $C_5$ zwischen dem Eingang des Verstärkers und Masse sowie aus einer Rückschleifkapazität $C_6$ zwischen dem Ausgang des Verstärkers und dem gemeinsamen Punkt der beiden Widerstände gebildet ist, dadurch gekennzeichnet, daß der durch das Substrat gebildetete Belag der Kapazität $C_5$ in dem elektrischen Schema über den Verstärker mit dem äußeren Belag der Kapazität $C_6$ verbunden ist und daß eine Lese- und Rückinjektionsvorrichtung zwischen den durch das Substrat gebildeten Belag $C_5$ und den Eingang des Verstärkers geschaltet ist, dessen Ausgang mit dem äußeren Belag der Kapazität $C_6$ verbunden ist.

0 030 173

Fig. 1

Fig. 2

Fig. 3

1

Fig. 4

Fig. 5

Fig. 6

Fig. 7

Fig. 8